Europäisches Patentamt

European Patent Office

Office européen des brevets

(19)

(11) **EP 0 548 391 B1**

(12) **EUROPÄISCHE PATENTSCHRIFT**

(45) Veröffentlichungstag und Bekanntmachung des Hinweises auf die Patenterteilung:
**23.07.1997 Patentblatt 1997/30**

(51) Int Cl.⁶: **G01R 33/06**, G01D 5/14

(21) Anmeldenummer: **91122046.5**

(22) Anmeldetag: **21.12.1991**

(54) **Offsetkompensierter Hallsensor**

Offset compensated Hall-sensor

Capteur de Hall avec décalage compensé

(84) Benannte Vertragsstaaten:
**CH DE FR GB IT LI NL**

(43) Veröffentlichungstag der Anmeldung:
**30.06.1993 Patentblatt 1993/26**

(73) Patentinhaber: **Deutsche ITT Industries GmbH**
**79108 Freiburg (DE)**

(72) Erfinder:
• **Mehrgardt, Sönke, Dr.rer.nat.**
**W-7806 March-Neuershausen (DE)**
• **Blossfeld, Lothar, Dipl.-Phys.**
**W-7800 Freiburg-Hochdorf (DE)**

(56) Entgegenhaltungen:
**DE-A- 2 333 080          DE-B- 1 194 971**

• **MICROELECTRONICS JOURNAL. Bd. 12, Nr. 6, 30. November 1981, LUTON GB Seiten 24 - 29; G.S.RANDHAWA: 'Monolithic integrated Hall-devices in silicon circuits'**
• **MACHINE DESIGN. Bd. 57, Nr. 23, 15. Oktober 1985, CLEVELAND US Seiten 83 - 87;**
• **J.R.HINES E.A,: 'New life for Hall-effect sensors'**
• **SENSOR AND ACTUATORS. Bd. A27, Nr. 1-3, 15. Mai 1991, LAUSANNE CH Seiten 747 - 751; P.J.A.MUNTER: 'Electronic cicuitry for a smart spinning-current Hall plate with low offset'**

## Beschreibung

Die Erfindung betrifft einen Hallsensor zur Messung von magnetischen Feldern, wobei der Hallsensor insbesonders als monolithisch integriertes Bauelement ausgeführt ist, das den Hallsensor, die Stromversorgung und die elektronischen Auswerteschaltungen für die Hallspannung enthält. Für die Herstellung dieser kombinierten Schaltung wird in der Regel eine der üblichen Silizium-Halbleitertechnologien verwendet, die den geläufigen Bipolar- oder MOS-Herstellungsprozessen entsprechen. Bekannte Nachteile von Silizium als Hall-Detektormaterial sind die geringe Hallempfindlichkeit und der große Einfluß des Piezoeffekts, der zu Offsetspannungsfehlern führt, die von den mechanischen Spannungen im Kristallgefüge und der richtungsabhängigen Hallempfindlichkeit bewirkt sind.

Die Empfindlichkeit von Hallsensoren hängt im wesentlichen von der Beweglichkeit der Ladungsträger und dem Stromfluss durch die Hallplatte ab. Die Auflösungsgrenze und Meßwertstreuung hängt insbesondere von der Streuung der verschiedenen Offsetspannungen ab, die von dem Hallsensor selbst und der nachfolgenden Elektronik abhängig sind.

Eine Hallplatte kann in erster Näherung als eine Widerstandsbrücke aufgefaßt werden, die auf "Null" abgeglichen ist, wenn kein Magnetfeld vorhanden ist. Herstellungsverfahren von Hallsensoren, bei denen die gewünschte Genauigkeit lediglich durch eine Selektion aus dem breiten Herstellungsspektrum erreicht werden kann, sind natürlich ganz unbefriedigend. Daher werden üblicherweise die Toleranzen bei der Herstellung mittels Kompensationsmethoden so klein wie möglich gehalten. Am meisten verbreitet ist die Kompensation der Hallplatten-Offsetspannung durch das Parallelschalten einer um 90° gedrehten zweiten Hallplatte, die der ersten möglichst äquivalent ist. Dadurch kann die Verstimmung der Widerstandsbrücke durch den Piezoeffekt in erster Näherung kompensiert werden. Dennoch verhindern Prozeßtoleranzen oder starke Spannungsgradienten im Kristall immer noch eine höhere Präzision der Magnetfeldbestimmung.

Ein Verfahren zur Kompensation der Offsetspannungen ist im Tagungsband "Proceedings of Eurosensors IV, 1991, Bd. 2, Seiten 747 bis 751 beschrieben, der sich auf eine Tagung in Karlsruhe vom 01. bis 03. Oktober 1990 bezieht. Das dort beschriebene Verfahren verwendet eine kreisförmige Hallplatte mit 16 gleichförmig an der Peripherie angebrachten Kontakten, die mittels elektronischer Schalter zirkular umgeschaltet werden. Die 16 zugehörigen Hallspannungen werden integriert, wodurch der Offsetfehler auf Werte kleiner als 50 Mikrovolt reduziert wird. In der zugehörigen Beschreibung wird angegeben, daß zwar Geometriefehler der Hallplatte durch eine Orthogonalumschaltung vollständig beseitigt werden können, nicht jedoch Offsetfehler infolge der vorbeschriebenen Piezoeffekte.

Da die störenden Offsetfehler bei Silizium oft wesentlich größer - beispielsweise bis zum Faktor 1000 - als die eigentlich zu bestimmende Hallspannung sein können, kommt noch ein spezieller Fehler der Auswerteschaltung hinzu. Bei idealer Gültigkeit der Brückenersatzschaltung tritt bei der Orthogonalumschaltung der Offsetfehler jeweils mit einem anderen Vorzeichen auf. Bei der Summierung der beiden orthogonalen Hallspannungen müßte sich der Offsetfehler auf diese Weise vollständig kompensieren. Dies gilt nur für den Fall, wenn für die verstärkten und weiterverarbeiteten Hallspannungen, eine strenge Proportionalität, Linearität, gleiche Verstärkung und Empfindlichkeit vorausgesetzt werden kann. Die Linearitäts- und Empfindlichkeitsanforderungen reichen in der Regel hierbei nicht aus.

Es ist daher Aufgabe der in den Ansprüchen gekennzeichneten Erfindung, einen Hallsensor mit einer verbesserten Kompensation der Offsetspannung anzugeben. Als weitere Aufgabe soll dabei der Hallsensor zusammen mit der Auswerteelektronik als monolithisch integriertes Bauelement in einer üblichen Halbleitertechnologie herstellbar sein.

Die Erfindung und ihre Vorteile werden nun anhand der Figuren der Zeichnung näher erläutert:

Fig. 1 zeigt schematisch einen vorkompensierten Hallsensor in der ersten Orthogonalposition,

Fig. 2 zeigt den vorkompensierten Hallsensor in der zweiten Orthogonalposition,

Fig. 3 zeigt schematisch die wesentlichen Schaltungsteile eines monolithisch integrierten Hallsensors,

Fig. 4 zeigt schematisch ein Hallelement, dessen Stromzuführung von den Meßkontakten getrennt ist,

Fig. 5 zeigt ein Ausführungsbeispiel eines vorkompensierten Hallsensors mit mehr als zwei Hallelementen und

Fig. 6 zeigt die Brückenersatzschaltung eines einzelnen Hallelementes.

Die Hallspannung Vh eines Hallelements setzt sich zusammen aus:

$$Vh = Rsq \times Ihall \times \mu h \times Bz + Voffset,$$

wobei Rsq der auf das Quadrat bezogenen Schichtwiderstand der Hallplatte, $\mu h$ die Hallbeweglichkeit und Bz die magnetische Feldstärke senkrecht zur Hallplatte angibt.

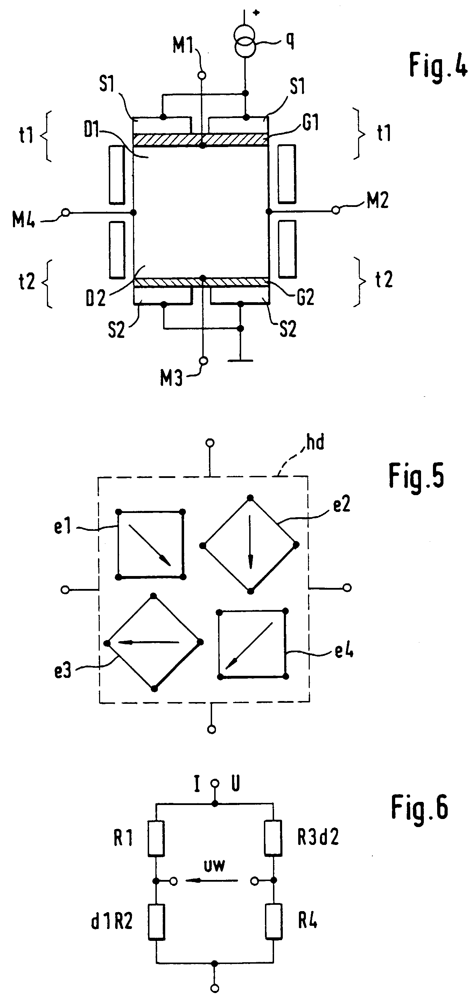

Bei der Annahme eines Brückenersatzschaltbildes nach Fig. 6 wirken sich die mechanische Spannungen im Kristall auf die Brücke im ungünstigsten Fall dadurch aus, daß sich die Widerstände R2 und R3 um den Faktor d1 bzw. d2 ändern. Bei der Umschaltung der Brücke um 90° oder bei der Parallelschaltung einer gleichen zweiten Brücke, die jedoch orthogonal angesteuert ist, kompensieren sich die Verstimmungsfaktoren d1, d2 vollständig.

Leider läßt sich dieses ideale Brückenmodell nicht vollständig auf eine offsetverstimmte Hallplatte anwenden. Wird nämlich zur Kompensation der Verstimmung wie üblich eine um 90° gedrehte zweite Hallplatte der ersten Hallplatte parallel geschaltet, dann wird in der zweiten Platte zwar eine Offsetspannung mit der umgekehrten Polarität erzeugt; eine vollständige Kompensation wird durch die Parallelschaltung oder Summierung der beiden Hallspannungen jedoch leider nicht erreicht, da in der zweiten Hallplatte die durch die mechanischen Spannungen bewirkten Streßverhältnisse unterschiedlich zu denen der ersten Platte sind. Nach der Erfindung wird die zweite Hallplatte jedoch lediglich zur Vorkompensation des Offsetfehlers benutzt - die eigentliche Kompensation findet erst durch die Orthogonalumschaltung und die Summierung der dabei gemessenen Hallspannungen statt. Die Vorkompensation nach der Erfindung hat auch den Vorteil, daß die beiden Hallplatten nicht um 90° gegeneinander ausgerichtet sein müssen, sondern der Winkel kann zwischen 0° und 180° beliebig sein. Dadurch können Winkel gewählt werden, die durch das Kristallgitter besonders streßanfällig sind.

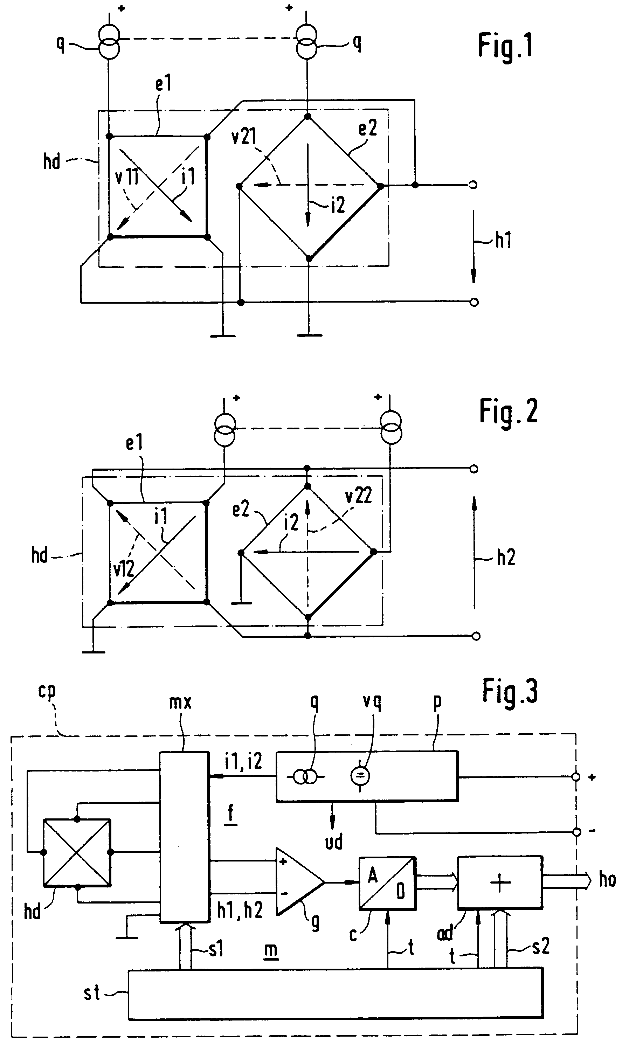

In Fig. 1 ist ein erstes und ein benachbartes zweites Hallelement e1, e2 zu einem Hallsensor hd zusammengeschaltet. Die Orientierungsrichtung ergibt sich aus der Orientierung des ersten bzw. zweiten Hallelement-Versorgungsstroms i1, i2. Somit stehen die beiden Hallelemente in einem Winkel von 45° zueinander. Der Strom wird in das Hallelement diagonal an den Eckpunkten eingespeist, wodurch die beiden anderen Eckpunkte als Hallspannungsabgriffe dienen. Jedes Hallelement ist aus einer eigenen Stromquelle q gespeist. Die Hallspannungsabgriffe sind parallelgeschaltet, und liefern an die Ausgangsklemmen einen ersten Hallspannungswert h1 als Parallelschaltwert.

Fig. 2 zeigt die gleiche Hallsensoranordnung wie Fig. 1, aber in der zweiten Orthogonalposition. Dadurch wird in den beiden Hallelementen e1, e2 die jeweilige Richtung des Hallelement-Versorgungsstromes i1, i2 um 90° umgeschaltet. Entsprechend werden die Hallspannungsabgriffe ebenfalls um 90° umgeschaltet. An den Ausgangsklemmen wird ein zweiter Hallspannungswert h2 als Parallelschaltwert abgegeben. Der Einfachheit wegen sind in Fig. 1 und Fig. 2 die jeweils parallelgeschalteten Hallspannungsabgriffe durch einen Schaltungsknoten zusammengeschaltet. In der tatsächlichen Ausführung darf dies kein fester Verbindungsknoten sein, da in der ersten und zweiten Orthogonalposition jeweils andere Hallspannungsabgriffe zusammengeschaltet werden müssen. Die Zusammenschaltung erfolgt daher durch elektronische Schalter in einer Schalterstufe mx, vgl. Fig. 3.

Fig. 3 zeigt schematisch ein Ausführungsbeispiel eines Hallsensors als monolithisch integrierte Schaltung auf einem Halbleiterchip cp. Dabei sind sowohl die erforderlichen Einrichtungen f und Schaltungsteile zur Orthogonalumschaltung des Hallsensor-Versorgungsstromes und der Hallspannungsabgriffe als auch die Auswertungseinrichtung m und die Summiereinrichtung ad, die für die weitere Verarbeitung der gemessenen Hallspannungen erforderlich sind, monolithisch auf dem Chip cp integriert. Die eigentliche Magnetfeldmeßeinrichtung ist der orthogonal umschaltbare Hallsensor hd, dessen Anschlußbeine mit einer elektronischen Schalterstufe mx verbunden sind. Über eine Steuereinrichtung st und Steuersignale s1 wird bestimmt, durch welche Anschlüsse die Versorgungsströme zu- oder abgeführt werden und an welchen Anschlüssen die Hallspannungen abzugreifen sind. Die Stromversorgung der Hallelemente erfolgt über eine Versorgungseinrichtung p, die extern mit einer ungeregelten Versorgungsspannung gespeist ist und über geregelte Stromquellen q die konstanten Hallelement-Versorgungsströme i1, i2 abgibt. Ferner enthält die Versorgungseinrichtung p eine Spannungsregelschaltung vq zur Abgabe der internen Versorgungsspannung ud für das gesamte Bauelement.

Die an den einzelnen Hallelementen im Halldetektor hd abgegriffenen Hallspannungen werden in der Schalterstufe mx parallelgeschaltet und bilden die Hallspannungswerte h1, h2, die einem hochohmigen Verstärker g zugeführt sind. Der Ausgang des Verstärkers g, der Teil der Hallspannungs-Auswertungseinrichtung m ist, ist mit dem Eingang einer Analog/Digital-Umsetzeinrichtung c verbunden, die die zugeführten Signale digitalisiert und einer digitalen Addierschaltung ad zuführt. Diese addiert den ersten und zweiten digitalisierten Hallspannungswert h1, h2 und gibt das Summensignal als offsetkompensierten Hallspannungswert ho ab. Die Addierschaltung ad ist durch ein zweites Steuersignal s2 von der Steuereinrichtung st gesteuert. Das Steuersignal s2 setzt beispielsweise den Akkumulator der Addierschaltung ad zurück, bevor ein neuer Meßzyklus beginnt.

Im Normalfall enthält jeder Zyklus nur die Summierung der Meßwerte der ersten und zweiten Orthogonalposition.

Selbstverständlich kann auch eine Summenbildung über vier aufeinanderfolgende Orthogonalpositionen durchgeführt werden, dies entspricht einem vollem Umlauf der Hallelement-Versorgungsströme im Hallsensor hd. Die Steuereinrichtung st gibt ferner Taktsignale t ab, mit denen die Digitalisierung, Summierung und Datenausgabe synchronisiert wird.

Die Grundform der Hallelemente erfordert wegen der notwendigen Geometriegleichheit bei der Orthogonalumschaltung eine Rotationssymmetrie. Dies wird durch die übliche quadratische Grundform der Hallelemente erfüllt. Die übliche Stromeinspeisung entlang einer Längsseite bringt jedoch bei der Quadraturumschaltung die Schwierigkeit mit sich, daß die Hallspannungsabgriffe mit den längsseitigen Stromkontakten kollidieren. Dieser Konflikt wird vermieden, wenn der Strom bei den quadratischen Hallelementen an den diagonal gegenüberliegenden Eckpunkten zu- oder abgeführt wird. An den beiden anderen Eckpunkten kann die Hallspannung abgegriffen werden. Bei einer Quadraturumschaltung werden lediglich die Strom- und Spannungskontakte miteinander vertauscht.

Fig. 4 zeigt schematisch ein quadratisches Hallelement, das eine Orthogonalumschaltung ermöglicht, obwohl die Stromflußrichtung parallel zu den Quadratseiten ist. Das Hallelement enthält dabei in der Mittenposition der jeweiligen Längsseite die Hallspannungs-Meßkontakte M1, M2, M3, M4. Die Ströme werden dem Hallelement jedoch kontaktfrei über MOS-Transistoren zugeführt bzw. abgeleitet. Längs jeder Quadratseite befinden sich längliche Zonen vom gleichen Leitfähigkeitstyp wie die Hallelementzone selbst. Diese länglichen Zonen bilden mit der Hallelementzone jeweils einen MOS-Transistor, wobei das Gate und der darunterliegende Kanal in der Zwischenzone gebildet sind. In Fig. 4 ist beispielsweise ein erster MOS-Transistor t1 schematisch dargestellt, dessen Source-Elektrode S1 mit der Stromquelle q verbunden ist und dessen Drain-Elektrode D1 die Hallelementzone selbst ist. Die Gate-Elektrode G1 wird von einem Steuersignal aus der Steuereinrichtung st in einen leitenden oder sperrenden Zustand gebracht. Die Ableitung des Stromes an der unteren Längsseite des Hallelementes erfolgt durch einen zweiten MOS-Transistor t2, dessen Source-Elektrode S2 mit dem Masseanschluß verbunden ist. Die Drain-Elektrode D2 bildet die Längsseite der Hallelementzone und die Gate-Elektrode G2 befindet sich zwischen diesen beiden Zonen.

Fig. 5 zeigt schematisch einen Hallsensor hd mit vier Hallelementen e1 bis e4. Durch die Parallelschaltung dieser vier Hallelemente werden vier verschiedene Richtungen für den Hallelement-Versorgungsstrom zur Vorkompensierung herangezogen. Dies ergibt natürlich einen noch besseren Ausgleich der richtungsabhängigen Piezoeffekte. Die zugehörige Schalterstufe muß sicherstellen, daß bei der Orthogonalumschaltung jeder einzelne Hallelement-Versorgungsstrom um 90° in seiner Richtung gedreht wird.

In Fig. 6 ist schematisch als Brückenschaltung die Ersatzschaltung eines rotationssymmetrischen Hallelements angegeben, bei der alle Widerstandswerte gleich sind, also R1 = R2 = R3 = R4. Die Brücke wird entweder mit einer konstanten Spannung U oder einem konstantem Strom I gespeist. Eine beliebige Verstimmung des Hallelements durch ein Geometriefehler oder durch einen mechanischen Streßfaktor wird in der Brückenersatzschaltung durch die Verstimmungsfaktoren d1, d2 des zweiten bzw. dritten Brückenwiderstandes R2, R3 berücksichtigt. Über mathematische Umformungen kann der Einfluß der Verstimmungsfaktoren d1, d2 in den beiden Orthogonalpositionen auf die jeweilige Brük-

kenspannung uw bestimmt werden, wobei noch zwischen einer Spannungs- oder Stromeinspeisung unterschieden werden kann.

Wenn sich die Brückenwiderstände bei der Orthogonalumschaltung nicht ändern, dann kompensieren sich die Verstimmungsfaktoren d1, d2 bei der Summation der beiden Brückenspannunen vollständig. Wie bereits eingangs angegeben, ändern sich jedoch die einzusetzenden Brückenwiderstände R1 bis R4 infolge des richtungsabhängigen Piezoeffekts und der richtungsabhängigen Hallempfindlichkeit. Wenn der Hallelement-Widerstand stromrichtungsabhängig ist, dann ist eine Stromsteuerung günstiger, weil der Strom durch eine hochohmige Konstantstromquelle konstant gehalten wird. Ein konstanter Strom ohne Temperaturabhängigkeit erzeugt zudem eine temperaturunabhängige Hallspannung, vgl. die eigene europäische Patentanmeldung 91 11 2840.3 (ITT-Case: U. Theus et al 16-1-1). Die dort beschriebene Stromquelle für den Hallelement-Versorgungsstrom ist zudem an den Schichtwiderstand Rsq der Hallelementzone gekoppelt, indem der erzeugte Strom bei einer bestimmten Bezugstemperatur To umgekehrt proportional zum Hallelement-Schichtwiderstand Rsq ist, weil dadurch die Hallelementempfindlichkeit weitgehend unabhängig von den Herstellungsparametern der Hallelementzone ist.

Die Hallelementzonen können auf verschiedene Weise hergestellt sein. Entweder aus einer relativ hochohmigen Zone, die diffundiert oder implantiert wird, einer Inversionsschicht, die mit Hilfe einer Gate-Elektrode erzeugt oder beeinfluß wird oder aus einzeln aufgebrachten dünnen Schichten, die beispielsweise über Sputter- oder CVD-Verfahren (CVD = Chemical Vapor Deposition) aufgebracht sind.

Wenn die Offset- und Linearitätsfehler der Auswerteinrichtung vernachlässigbar sind, dann können in der Summiereinrichtung oder in der Addierschaltung ad auch die einzelnen Hallspannungen v11, v21; v12, v22 direkt addiert werden. Die Vorkompensation, bei der die Hallspannungswerte h1, h2 ermittelt werden, findet dann nur als Rechenschritt statt.

**Patentansprüche**

1. Offsetkompensierter Hallsensor mit

- einer Einrichtung (f) zur Orthogonalumschaltung des Hallsensor-Versorgungsstroms und der Hallspannungsabgriffe, wobei die Geometrie des Hallsensors (hd) in der ersten und zweiten Orthogonalposition für die Hallspannungsbestimmung gleich ist,

- einer Summiereinrichtung, der ein erster und ein zweiter Hallspannungswert (h1, h2) zur Bildung eines offsetkompensierten Hallspannungswertes (ho) zugeführt ist,

gekennzeichnet durch folgende Merkmale:

- der Hallsensor (hd) enthält mindestens ein erstes und ein zweites Hallelement (e1, e2),

- das erste und zweite Hallelement (e1, e2) sind geometrisch aneinander gleich, auf einem gemeinsamen Träger mit derselben Technologie hergestellt und, thermisch und räumlich eng verkoppelt und jeweils orthogonal umschaltbar,

- der erste Hallspannungswert (h1) ist die Summe oder der Parallelschaltwert aus den jeweiligen Hallspannungswerten (v11, v21) des ersten und zweiten Hallelements (e1, e2) in der ersten Orthogonalposition,

- der zweite Hallspannungswert (h2) ist die Summe oder der Parallelschaltwert aus den jeweiligen Hallspannungswerten (v12, v22) des ersten und zweiten Hallelements (e1, e2) in der zweiten Orthogonalposition und

- die geometrische Ausrichtung des ersten und zweiten Hallelements (e1, e2) in der ersten Orthogonalposition schließt einen von 0° und 180° verschiedenen Winkel ein, der in der zweiten Orthogonalposition um 90° gedreht ist, wobei die geometrische Ausrichtung auf die Richtung der Hallelement-Versorgungsströme (i1, i2) bezogen ist.

2. Hallsensor nach Anspruch 1, dadurch gekennzeichnet, daß die Hallelemente (e1, e2) mit einer Auswerteeinrichtung (m) und der Einrichtung (f) gemeinsam auf einer Halbleiteroberfläche monolithisch integriert sind.

3. Hallsensor nach Anspruch 2, dadurch gekennzeichnet, daß die Hallspannungen (v11, v21; v12, v22) oder der erste und zweite Hallspannungswert (h1, h2) mittels einer Analog/Digital-Umsetzeinrichtung (c) digitalisiert sind und daß die Summiereinrichtung eine digitale Addierschaltung (ad) enthält.

4. Hallsensor nach Anspruch 2, dadurch gekennzeichnet, daß die Hallelemente (e1, e2) mittels diffundierter oder implantierter Zonen auf der Halbleiteroberfläche gebildet sind.

5. Hallsensor nach Anspruch 2, dadurch gekennzeichnet, daß die Hallelemente (e1, e2) mittels Inversionsschichten auf der Halbleiteroberfläche gebildet sind, die mittels Gate-Elektroden erzeugt oder beeinflußt sind.

6. Hallsensor nach Anspruch 2, dadurch gekennzeichnet, daß die Hallelemente (e1, e2) aus dünnen Schichten bestehen, die auf der Halbleiteroberfläche, insbesondere durch Sputter- oder CVD-Verfahren, aufgebracht sind.

7. Hallsensor nach Anspruch 2, dadurch gekennzeichnet, daß die Hallelemente (e1, e2) an Einrichtungen zur Versorgungsstromeinspeisung und Versorgungsstromabnahme gekoppelt sind, die von den Meßkontakten getrennt sind.

8. Hallsensor nach Anspruch 7, dadurch gekennzeichnet, daß bei den Hallelementen (e1, e2) die Stromeinspeisung und die Stromabnahme kontaktlos durch jeweils einen MOS-Transistor (t1, t2) erfolgt, dessen eine Elektrode die Widerstandszone des jeweiligen Hallelements (e1, e2) ist.

9. Hallsensor nach Anspruch 2, dadurch gekennzeichnet, daß eine thermisch mit den Hallelementen (e1, e2) gekoppelte und mit derselben Technologie hergestellte Konstantstromquelle (q) temperaturunabhängige Konstantströme zur Speisung der Hallelemente (e1, e2) erzeugt, wobei der Wert der Konstantströme umgekehrt proportional zum Schichtwiderstand (Rsq) der Hallelemente bei einer im Arbeitsbereich liegenden Bezugstemperatur (To) ist.

10. Hallsensor nach Anspruch 1, dadurch gekennzeichnet, daß dem ersten und zweiten Hallelement (e1, e2) weitere geometrisch gleiche Hallelemente (e3, e4) zur Vorkompensation der Offsetspannung parallelgeschaltet sind, die ebenfalls orthogonal umschaltbar sind.

**Claims**

1. An offset-compensated Hall sensor comprising

- a device (f) for orthogonally switching the Hall sensor supply current and the Hall-voltage taps, the geometry of the Hall sensor (hd) in the first and second orthogonal positions for the Hall-voltage determination being the same, and

- a summing device fed with a first and a second Hall-voltage value (h1, h2) for forming an offset-compensated Hall-voltage value (ho),

characterized by the following features:

- The Hall sensor (hd) contains at least a first Hall cell (e1) and a second Hall cell (e2);

- the first and second Hall cells (e1, e2) are geometrically identical, fabricated on a common substrate using the same technology, thermally and spatially closely coupled, and each orthogonally switchable;

- the first Hall-voltage value (h1) is the sum, or the parallel switching value, of the respective Hall-voltage values (v11, v21) of the first and second Hall cells (e1, e2) in the first orthogonal position;

- the second Hall-voltage value (h2) is the sum, or parallel switching value, of the respective HaLl voltages (v12, v22) of the first and second Hall cells (e1, e2) in the second orthogonal position, and

- the geometrical orientation of the first and second Hall cells (e1, e2) in the first orthogonal position includes an angle other than 0° or 180° which is rotated by 90° in the second orthogonal position, with the geometrical orientation referred to the direction of the Hall cell supply currents (i1, i2).

2. A Hall sensor as claimed in claim 1, characterized in that the Hall cells (e1, e2), an evaluating device (m), and the device (f) for orthogonally switching the Hall detector supply current are integrated on a common semiconductor surface.

3. A Hall sensor as claimed in claim 2, characterized in that the Hall voltages (v11, v21; v12, v22) or the first and second Hall-voltage values (h1, h2) are digitized by means of an analog-to-digital converter (c), and that the summing device comprises a digital adder (ad).

4. A Hall sensor as claimed in claim 2, characterized in that the Hall cells (e1, e2) are formed in or upon the semiconductor surface by means of diffused or implanted regions.

5. A Hall sensor as claimed in claim 2, characterized in that the Hall cells (e1, e2) are formed upon the semiconductor surface by means of inversion layers which are produced or influenced by means of gate electrodes.

6. A Hall sensor as claimed in claim 2, characterized in that the Hall cells (e1, e2) consist of thin layers deposited on the semiconductor surface, particularly by sputtering or by chemical vapor deposition.

7. A Hall sensor as claimed in claim 2, characterized in that the Hall cells (e1, e2) are coupled to devices for supply-current injection and supply-current collection which are separate from the measuring contacts.

8. A Hall sensor as claimed in claim 7, characterized in that current is injected into and taken from the Hall cells (e1, e2) contactlessly through MOS transistors (t1, t2), one electrode of each of which is the resistive region of the respective Hall cell (e1, e2).

9. A Hall sensor as claimed in claim 2, characterized in that a constant-current source (q) thermally coupled with the Hall cells (e1, e2) and fabricated using the same technology generates temperature-independent constant currents for feeding the Hall cells (e1, e2), with the value of the constant currents being inversely proportional to the sheet resistivity (Rsq) of the Hall cells at a reference temperature (To) lying in the operating range.

10. A Hall sensor as claimed in claim 1, characterized in that further geometrically identical and orthogonally switchable Hall cells (e3, e4) for offset-voltage precompensation are connected in parallel with the first and second Hall cells (e1, e2).

**Revendications**

1. Capteur à effet Hall compensé en décalage comprenant :

- un dispositif (f) pour une commutation orthogonale du courant d'alimentation du capteur à effet Hall et des prises de tension de Hall, la géométrie du capteur à effet Hall (hd) étant égale dans la première et la deuxième positions orthogonales pour la détermination de la tension de Hall,
- un dispositif de sommation, auquel sont acheminées une première et une deuxième valeurs de tension de Hall (h1, h2) pour former une valeur de tension de Hall (ho) compensée en décalage,

caractérisé en ce que :

- le capteur à effet Hall (hd) contient au moins un premier et un deuxième éléments à effet Hall (e1, e2),
- le premier et le deuxième éléments à effet Hall (e1, e2) sont géométriquement identiques l'un à l'autre, sont produits sur un support commun avec la même technologie, sont couplés étroitement aux plans thermique et spatial et sont respectivement commutables orthogonalement,
- la première valeur (h1) de la tension de Hall est la somme ou la valeur de couplage en parallèle formée des valeurs de tension de Hall respectives (v11, v21) du premier et du deuxième éléments à effet Hall (e1, e2) dans la première position orthogonale,

- la deuxième valeur (h2) de la tension de Hall est la somme ou la valeur de couplage en parallèle formée des valeurs de tension de Hall respectives (v12, v22) du premier et du deuxième éléments à effet Hall (e1, e2) dans la deuxième position orthogonale, et
- l'orientation géométrique du premier et du deuxième éléments à effet Hall (e1, e2) dans la première position orthogonale inscrit un angle différent de zéro et de 180°, qui est soumis à une rotation de 90° dans la deuxième position orthogonale, l'orientation géométrique étant rapportée à la direction des courants d'alimentation (i1, i2) des éléments à effet Hall.

2. Capteur à effet Hall selon la revendication 1, caractérisé en ce que les éléments à effet Hall (e1, e2) sont intégrés de manière monolithique sur une surface semi-conductrice, conjointement avec un dispositif d'exploitation (m) et le dispositif (f).

3. Capteur à effet Hall selon la revendication 2, caractérisé en ce que les tensions de Hall (vll, v21; v12, v22) ou la première et la deuxième valeurs de tension de Hall (h1, h2) sont numérisées au moyen d'un convertisseur analogique/numérique (c) et en ce que le dispositif de sommation contient un circuit d'addition numérique (ad).

4. Capteur à effet Hall selon la revendication 2, caractérisé en ce que les éléments à effet Hall (e1, e2) sont formés au moyen de régions diffusées ou implantées sur la surface semi-conductrice.

5. Capteur à effet Hall selon la revendication 2, caractérisé en ce que les éléments à effet Hall (e1, e2) sont formés au moyen de couches d'inversion sur la surface semi-conductrice, lesdites couches étant produites ou influencées au moyen d'électrodes de grille.

6. Capteur à effet Hall selon la revendication 2, caractérisé en ce que les éléments à effet Hall (e1, e2) sont constitués de couches minces, qui sont appliquées sur la surface semi-conductrice, en particulier par pulvérisation cathodique ou par un procédé CVD.

7. Capteur à effet Hall selon la revendication 2, caractérisé en ce que les éléments à effet Hall (e1, e2) sont couplés à des dispositifs d'alimentation en courant et d'évacuation de courant, qui sont séparés des contacts de mesure.

8. Capteur à effet Hall selon la revendication 7, caractérisé en ce que, dans les éléments à effet Hall (e1, e2), l'alimentation en courant et l'évacuation du courant se font sans contact, respectivement, par un transistor MOS (t1, t2), dont une électrode est la région de résistance de l'élément à effet Hall respectif (e1, e2).

9. Capteur à effet Hall selon la revendication 2, caractérisé en ce qu'une source de courant constant (q) couplée thermiquement aux éléments à effet Hall (e1, e2) et fabriquée avec la même technologie produit des courants constants indépendants de la température pour alimenter les éléments à effet Hall (e1, e2), la valeur des courants constants étant inversement proportionnelle à la résistance série (Rsq) des éléments à effet Hall à une température de référence (To) se situant dans la plage de travail.

10. Capteur à effet Hall selon la revendication 1, caractérisé en ce que d'autres éléments à effet Hall géométriquement identiques (e3, e4) sont montés en parallèle avec le premier et le deuxième éléments à effet Hall (e1, e2) pour pré-compenser la tension décalée et peuvent également être soumis à une commutation orthogonale.

Fig.1

Fig.2

Fig.3

Fig.4

Fig.5

Fig.6